# EUROPÄISCHE PATENTSCHRIFT

(11) **EP 1 181 852 B1**
(45) Veröffentlichungstag und Bekanntmachung des Hinweises auf die Patenterteilung: **26.03.2003**
(21) Anmeldenummer: 00938724.2
(22) Anmeldetag: 31.05.2000
(51) Int. Cl.: H05K 7/20, G06F 1/20

(54) **GEHÄUSEANORDNUNG ZUR AUFNAHME ELEKTRONISCHER BAUGRUPPEN, INSBESONDERE FLACHES DESKTOP-PC- ODER MULTIMEDIA-GEHÄUSE**
HOUSING SYSTEM FOR HOUSING ELECTRONIC COMPONENTS, ESPECIALLY A FLAT DESKTOP PC OR MULTIMEDIA HOUSING
ENSEMBLE BOITIER POUR LOGER DES UNITES ELECTRONIQUES, EN PARTICULIER BOITIER PLAT POUR PC DE BUREAU OU SYSTEME MULTIMEDIA

(30) Priorität: 01.06.1999 DE 29909556 U
(43) Veröffentlichungstag der Anmeldung: 27.02.2002
(73) Patentinhaber: Dalheimer, Volker, 64747 Breuberg (DE)
(72) Erfinder: Dalheimer, Volker, 64747 Breuberg (DE)
(74) Vertreter: Heinze, Ekkehard, Dipl.-Phys. Dr.
(86) Internationale Anmeldenummer: EP0005022
(87) Internationale Veröffentlichungsnummer: WO00074458

(56) Entgegenhaltungen:
- DE-U- 9 005 147
- DE-U- 9 108 160
- US-A- 5 694 294
- PATENT ABSTRACTS OF JAPAN vol. 1998, no. 09, 31. Juli 1998 (1998-07-31) & JP 10 098139 A (HITACHI LTD), 14. April 1998 (1998-04-14)
- COLE - GUPTA: "Push/ Pull Cooling System with Single Blower. December 1982." IBM TECHNICAL DISCLOSURE BULLETIN, Bd. 25, Nr. 7B, 1. Dezember 1982 (1982-12-01), Seiten 3904-3905, XP002147472 New York, US in der Anmeldung erwähnt
- DOODY - GUPTA: "Induced Cooling in a Unit Cooling Scheme. December 1982." IBM TECHNICAL DISCLOSURE BULLETIN, Bd. 25, Nr. 7B, 1. Dezember 1982 (1982-12-01), Seiten 3906-3908, XP002147473 New York, US in der Anmeldung erwähnt

## Beschreibung

Die Erfindung betrifft eine Gehäuseanordnung zur Aufnahme elektronischer Baugruppen, insbesondere flaches Desktop-PCoder Multimedia-Gehäuse, umfassend eine Bodenplatte, Frontseite und Rückseite sowie einen haubenartigen, abnehmbaren Deckel, einen elektromotorischen Lüfter und im Gehäuse gebildete Kammern oder Abschnitte, gemäß Oberbegriff des Patentanspruchs 1.

Aus dem deutschen Gebrauchsmuster G 91 08 160.2 ist ein Außengehäuse für einen magneto-optischen Massenspeicher bekannt, das einen Lüfter aufweist, welcher über einen geeigneten Filter einen gezielten Luftstrom in das Gehäuse einbringt, und zwar derart, dass dieser Luftstrom durch das Laufwerk des Speichers geführt werden kann. Die Stromversorgungseinheit ist bei dem derartigen Gehäuse seitlich beabstandet vom Laufwerk angeordnet und wird ebenfalls über einen Teilluftstrom gekühlt. Der Einsatz eines Filters ist notwendig, da Verunreinigungen der Schreib/Leseeinheit eines magneto-optischen Speichers zu dessen Ausfall führen können.

Ein sogenannter Kompakt-Industriecomputer ist im Gebrauchsmuster G 90 05 147.5 offenbart. Dort soll ebenfalls die Möglichkeit der Kühlung von Komponenten erfolgen, die innerhalb des Computers befindlich sind. Konkret sollen kürzere Steckkarten und ein frontal eingebauter Lüfter Anwendung finden, so dass im Vergleich zu bis dahin Bekanntem die Einbautiefe reduziert ist. Bei vorgesehener Schaltschrankmontage soll die Luft im vorderen Bereich angesaugt werden und im hinteren Bereich des Gehäuses austreten. Bei freier Montage in belasteter Umgebung ist gemäß G 90 05 147.5 das Gehäuse abgedichtet und es werden Filter eingesetzt. Die dann vorgesehenen Lüfter blasen in entgegengesetzte Richtungen, so dass innerhalb des Computers eine Luftzirkulation unter Rückgriff auf Luftleitbleche erreichbar ist. In einer Ausgestaltung sind die dortigen Filtermatten durch einen Wärmetauscher ersetzt, so dass zwischen einem inneren Luftzirkulations-Kreislauf und einer äußeren Wärmeabführung zu unterscheiden ist.

Weiterhin ist aus dem IBM Technical Disclosure Bulletin, Vol.25, Nr.7B, Dezember 1982, eine Kühleinheit mit optimierter Kühlluftführung innerhalb eines Datenverarbeitungssystems bekannt. Der dort vorgesehene Lüfter ist in der Nähe eines CPU-Kühlkörpers mit diesem verbunden angeordnet, wobei der Luftstrom über Einlassöffnungen im Gehäuse zunächst zu einem Schaltnetzteil und dann erst zur Kühlung der CPU herangezogen wird. Die Luftaustrittsöffnung befindet sich an der Oberseite des Geräts.

Den vorstehend geschilderten Gehäuseanordnungen mit integrierter Lüftung ist jedoch eine nicht optimierte Kühlluftströmung, insbesondere unter dem Aspekt einer unerwünschten Geräuschbildung gemein. Bei Gehäuseanordnungen, die elektronische Geräte, z.B. Multimedia-Einrichtungen aufnehmen und die auch im Heimbereich Anwendung finden, gilt es grundsätzlich, die Geräuschemission des Geräts selbst, die vom Nutzer als störend empfunden wird, gering zu halten.

Aus US-A-5 694 294 ist ferner eine weitere Gehäuseanordnung zur Aufnahme elektronischer Baugruppen bekannt.

Aus dem Vorgenannten ist es daher Aufgabe der Erfindung, eine weitergebildete Gehäuseanordnung zur Aufnahme elektronischer Baugruppen, insbesondere ein flaches Desktop-PC- oder Multimedia-Gehäuse anzugeben, welches eine optimierte Kühlung der im Inneren befindlichen Komponenten bei gleichzeitiger minimaler Geräuschemission erreicht, so dass einerseits gesetzlichen Erfordernissen für den Einsatz derartiger Geräte am Arbeitsplatz Genüge getan ist und andererseits sich im privaten Bereich die Verwendung eines solchen Geräts nicht als störend erweist.

Die Lösung der Aufgabe der Erfindung erfolgt mit einem Gegenstand nach den Merkmalen des Patentanspruchs 1, wobei die Unteransprüche mindestens zweckmäßige Ausgestaltungen und Weiterbildungen umfassen.

Erfindungsgemäß ist im Gehäuseinneren ein im wesentlichen zur Bodenplatte parallel und von dieser höhenmäßig beabstandet verlaufender Frischluftkanal vorgesehen, wobei der Frischluftkanal außer seitlichen Lufteintrittsöffnungen gegen das übrige Gehäuse und den im Gehäuseinneren befindlichen Kammern oder Abschnitten saugseitig abgedichtet ist.

Am lufteintrittsöffnungsfernen Ende des Frischluftkanals ist eine Ausnehmung zur Aufnahme eines Lüfters eingebracht, wobei der Lüfter so ausgebildet ist, dass dieser vertikal in die unterhalb des Frischluftkanals befindliche Kammer bläst.

Die untere Kammer steht mit einem seitlichen Abluftkanal in Verbindung, über welchen zwangsgeführt die erwärmte Abluft das Gehäuse seitlich verlässt.

In Strömungsrichtung unterhalb des Lüfters, von diesem angeblasen, befindet sich mindestens eine elektronische Baugruppe und Wärmequelle, insbesondere eine CPU mit Kühlkörper. Der Ausnehmung zur Aufnahme des Lüfters strömungsseitig vorgeordnet ist eine weitere Ausnehmung im Frischluftkanal vorgesehen, die zur Befestigung einer zu kühlenden Baugruppe dient. Diese Baugruppe reicht in die untere Kammer hinein. Letztere Baugruppe kann insbesondere ein Festplatten-Laufwerk sein, wobei der zu kühlende Flächenabschnitt von der weiteren Ausnehmung umfasst wird. Gleichzeitig besteht die Möglichkeit, diese Festplatte geräuschdämmend unter Verwendung einer elastischen Lagerung in der weiteren Ausnehmung zu befestigen.

Der Frischluftkanal ist aus einem Blechform- oder Spritzgussteil herstellbar, wobei der haubenartige Deckel seitliche Lufteintrittsöffnungen besitzt und den Frischluftkanal nach oben abdichtet.

Im seitlichen Abluftkanal ist eine Stromversorgungs-Baugruppe, insbesondere ein Schaltnetzteil in open-frame-Bauweise angeordnet. Der Abluftkanal wird von einer gehäuseinnenseitigen Trennwand und von dem haubenartigen Deckel gebildet, wobei der Deckel seitliche Öffnungen für den Luftaustritt aufweist.

Der Deckel besitzt insbesondere eine im wesentlichen U-Form, wobei in einem Schenkel die Lufteintritts- und im gegenüberliegenden zweiten Schenkel die Luftaustrittsöffnungen eingebracht sind. Diese Öffnungen können z.B. durch Stanzen oder Bohren realisiert werden.

Weitere zu kühlende Baugruppen sind an der gehäuseinnenseitigen Trennwand, mit dieser in Wärmekontakt stehend, angeordnet.

Durch die Anordnung einer elektronischen Baugruppe, insbesondere einer CPU mit passivem Kühlkörper unterhalb des Lüfters, erfolgt ein unmittelbares Anblasen dieses Kühlkörpers und ein zusätzliches erwünschtes Verwirbeln des Luftstroms.

Neben der geräuschdämmenden Lagerung und Befestigung der Festplatte in der weiteren Ausnehmung kann ebenso der Lüfter in der erstgenannten Ausnehmung körperschallisoliert fixiert werden.

Der Lüfter baut innerhalb der unteren Kammer einen Überdruck auf, wobei die gehäuseinnenseitige Trennwand in einem hinteren Bereich Luftdurchtrittsöffnungen umfasst. Die Trennwand ist in Form einer doppelten Abkantung ausgestaltet, wodurch eine weitere Kammer zur Aufnahme des erwähnten insbesondere openframe-Schaltnetzteils gebildet ist.

Die längere Seite der Trennwand wird parallel und beabstandet zum zweiten Schenkel des Deckels, mindestens bis hin zu den dort gesehenen Luftaustrittsöffnungen geführt.

Die mindestens eine in der unteren Kammer angeordnete elektronische Baugruppe kann von der Frontseite des Gehäuse über eine Klappe, Schiebeteil oder dergleichen Mittel zugänglich sein.

Mit dem vorgestellten Gehäuse ergibt sich ein spezieller Kühlluft-Strömungsverlauf, der von einem seitlichen Lufteintritt mit zunächst horizontalem Verlauf innerhalb des Frischluftkanals ausgeht, wobei dann eine Richtungsumkehr vertikal nach unten in die untere Kammer mit Überdruckaufbau und Verwirbelung stattfindet. Eine weitere Richtungsumkehr erfolgt horizontal in den seitlichen Abluftkanal hinein, wobei hier ein Abbau des Drucks über den seitlichen Luftaustritt und die dort vorgesehenen Gehäuseöffnungen erfolgt, die denjenigen für den Lufteintritt gegenüberliegen.

Die Gehäusekonzeption ist weiterhin von einem Split-Level-Flachaufbau getragen, wobei in einer unteren Ebene Quellen größerer Wärmeentwicklung, in einer mittleren Ebene Quellen mittlerer bis geringerer Wärmeentwicklung und in einer oberen Ebene ein Frischluftkanal mit Zwangsströmung befindlich ist, wobei diese Zwangsströmung von oben nach unten und seitlich austretend verläuft.

Im Bereich des Luftaustritts der unteren Ebene benachbart ist ein höhenmäßig über alle Ebenen reichender Abluftkanal befindlich, in den mindestens eine weitere, thermisch allerdings unterkritische Wärmequelle anordenbar ist.

Erfindungsgemäß erfolgt eine gezielte Ansaugung der zu kühlenden Luft über einen speziellen Frischluftkanal, der gegen das Gehäuse saugseitig abgedichtet ist. Dieser Luftkanal dient gleichzeitig als obere Befestigung eines insbesondere Festplatten-Laufwerks und hat im Bereich der Festplatte gegen das Festplattengehäuse eine abgedichtete Öffnung oder Ausnehmung, über die die Festplatte am Oberteil kontinuierlich durch die Luftströmung der angesaugten Luft beaufschlagt und gekühlt wird.

Der einzige im Gehäuse zum Einsatz kommende Lüfter ist in waagerechter Position am Ende des Luftkanals in z.B. Gummi oder ähnlichem elastischen Material gelagert und befestigt und strömt senkrecht nach unten direkt auf den darunter befindlichen passiven Kühlkörper der CPU bzw. des Prozessors. Hierdurch kommt es wie erwähnt zu einer zusätzlichen Verwirbelung der Luftströmung, die zur Kühlung der übrigen elektronischen Komponenten beiträgt.

Aufgrund des Abdichtens des Luftkanals gegen das Gehäuse entsteht gleichzeitig innerhalb des Gehäuses ein Überdruck, der durch entsprechend großzügig ausgelegte Öffnungen in der gegen das Gehäuse abgedichteten Trennwand, die gleichzeitig den Luftabfuhrkanal darstellt, einen gezielten Luftstrom über den passiven Kühlkörper des Schaltnetzteils verursacht und dessen Kühlung sicherstellt. Die Ausnehmung zur Aufnahme des Festplattenspeichers ist geringfügig größer als die Platte selbst dimensioniert und bevorzugt mit Moosgummi ausgekleidet. In diesem Moosgummimaterial wird die Festplatte gelagert und von oben durch den Saugkanal wiederum über Moosgummistreifen fest angepresst, so dass bei einer derartigen Ausführungsform eine stabile unverrückbare Lagerung gegeben ist und eine Körperschallübertragung weitgehendst vermindert wird.

Es gelingt insbesondere bei dieser Ausführungsform unter Anwendung von Festplattenspeichern sehr hoher Drehzahlen, einerseits die relativ großen Wärmeverluste abzuführen und andererseits die auftretenden Geräusche zu senken.

Die Erfindung soll nachstehend anhand eines Ausführungsbeispiels sowie von Figuren näher beschrieben werden.

Hierbei zeigen:
- Fig. 1: einen Längsschnitt durch eine Gehäuseanordnung gemäß Ausführungsbeispiel;
- Fig. 2: eine Zusammenstellungszeichnung mit Frischluftkanal, Lüfter und haubenartigem Deckel;
- Fig. 3: eine Darstellung mit komplett montiertem Frischluftkanal vor dem Aufsetzen des haubenartigen Deckels;
- Fig. 4: eine Prinzipdarstellung des Strömungsverlaufs; und
- Fig. 5: eine prinzipielle Darstellung des Split-Level-Gehäuseaufbaus.

Das Gehäuse 1 gemäß Ausführungsbeispiel besitzt eine Bodenplatte 2 und einen Deckel 4 mit einer U-Form. Der Deckel 4 nimmt Lufteintrittsöffnungen 41 sowie Luftaustrittsöffnungen 42 auf. Ein Formteil 3 bildet einen Frischluftkanal, wobei der Kanal saugseitig mit den Lufteintrittsöffnungen 41 in Verbindung steht. Eine Ausnehmung 31 im Formteil 3 nimmt einen Lüfter 5 auf. Dieser Lüfter bläst senkrecht nach unten und die Luftströmung trifft auf eine dort befindliche elektronische Baugruppe 7, insbesondere eine CPU mit passivem Kühlkörper.

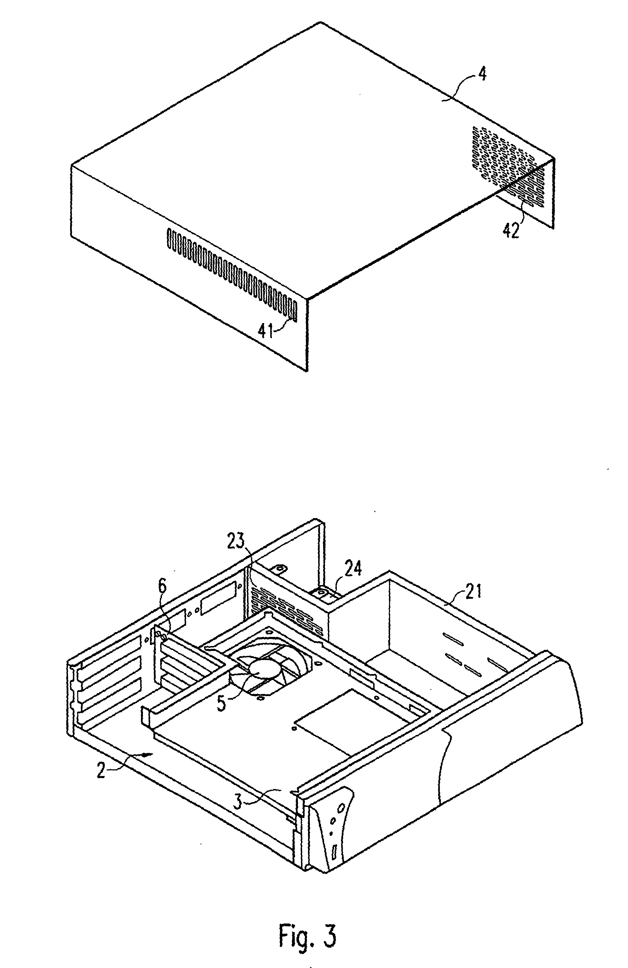

In diesem unteren Bereich bzw. der unteren Kammer des Gehäuses erfolgt eine Verwirbelung und Strömungsumkehr hin zu einer gehäuseinnenseitigen Trennwand 21, die eine Abkantung 23 mit Luftdurchtrittsöffnungen hin zum Abluftkanal besitzt. In einem Teil 24 des Abluftkanals kann gemäß Fig. 3 ein Netzteil, insbesondere in einer dort gebildeten Kammer aufgenommen sein.

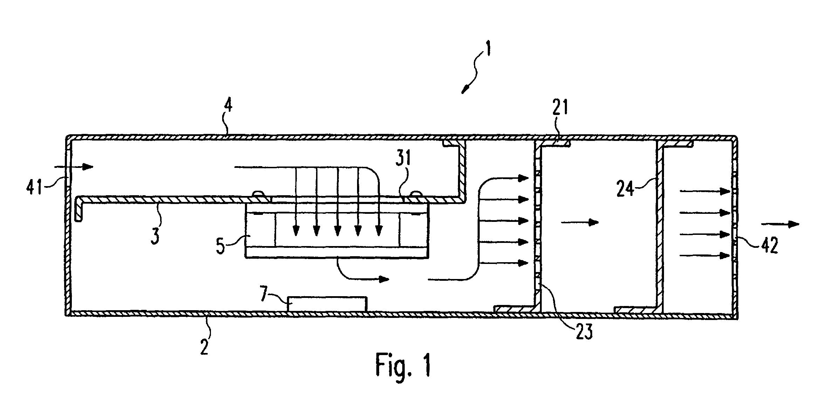

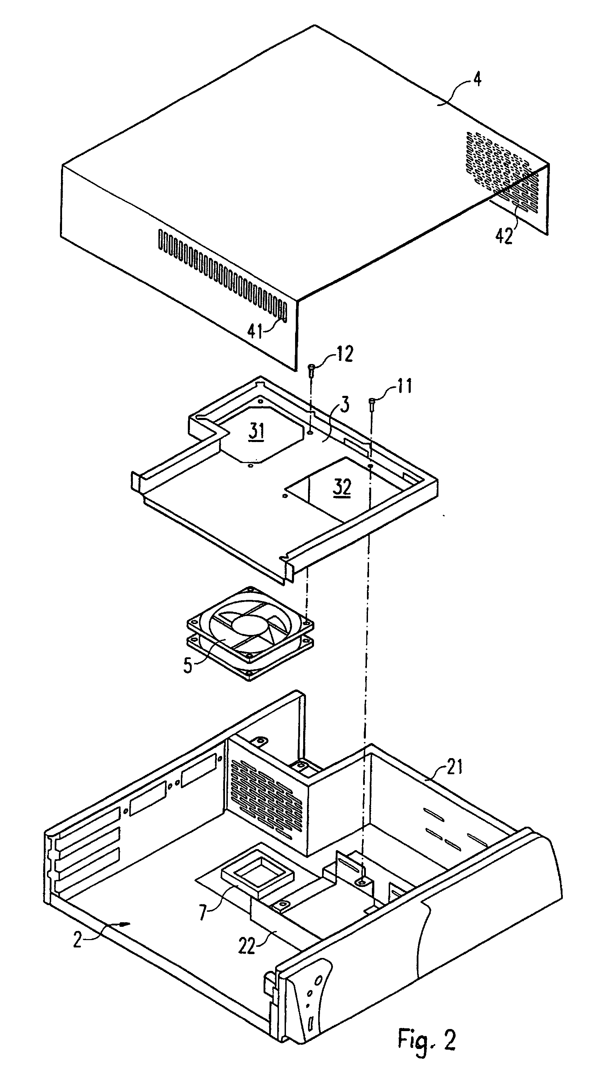

Fig. 2 läßt in perspektivischer Form die einzelnen maßgeblichen Gehäusekomponenten erkennen. So nimmt die Bodenplatte 2 die Halterung 7 für eine CPU auf und es ist eine weitere Halterung 22 mit Seitenführung z.B. für eine Festplatte, ein DVD- oder FDD-Laufwerk vorgesehen. Die gehäuseinnenseitige Trennwand 21 bildet zum entsprechenden Schenkel des Deckels 4 den Abluftkanal mit einer größeren Kammer im Rahmen der Abkantung 23 (siehe Fig. 1), die der Aufnahme eines Schaltnetzteils dient.

Das Formteil 3 zur Bildung des Frischluftkanals weist die Ausnehmung 31 für den Lüfter und die Ausnehmung 32 für eine weitere zu kühlende Baugruppe, insbesondere die erwähnte Festplatte auf. 11 und 12 stellen Befestigungsbolzen dar.

Bei montiertem Formteil 3 mit dort eingesetztem Lüfter 5 lässt sich bereits der Frischluftkanal gemäß Fig. 3 erkennen. Darstellungsseitig links strömt über die Öffnungen 41 bei aufgesetztem Deckel 4 Frischluft in diesen Kanal ein und wird vom Lüfter 5 vertikal nach unten auf die dort befindliche elektronische Baugruppe gelenkt. Der sich ergebende Unterdruck wird dann über die Abkantung 23 mit Luftdurchtrittsöffnungen hin zum Abluftkanal 24 geführt, wobei dieser Kanal von der gehäuseinnenseitigen Trennwand 21 und dem zugehörigen Schenkel des Deckels 4 gebildet ist. In der unteren Kammer ist weiterhin eine Karte mit Steckverbindern zur Aufnahme von verdrahteten Platinen (nicht gezeigt) vorgesehen.

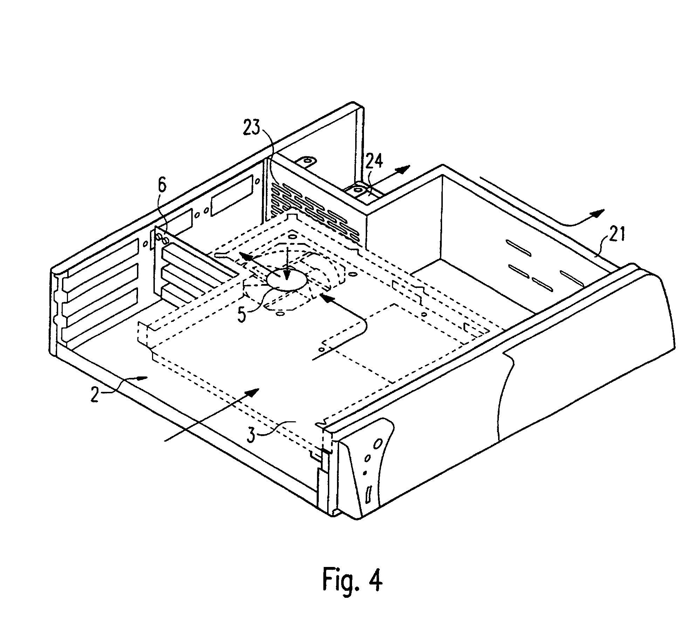

Fig. 4 macht mit den Pfeildarstellungen noch einmal die Zuund Abluftströmung deutlich.

Es erfolgt demnach ein seitlicher Lufteintritt mit horizontalem Verlauf innerhalb des Frischluftkanals, eine Richtungsumkehr vertikal nach unten in die untere Kammer mit Überdruckaufbau und Verwirbelung, eine weitere Richtungsumkehr horizontal in den seitlichen Abluftkanal hinein und Abbau des Drucks durch seitlichen Luftaustritt über Öffnungen des Gehäuses, die denjenigen für den Lufteintritt gegenüberliegen.

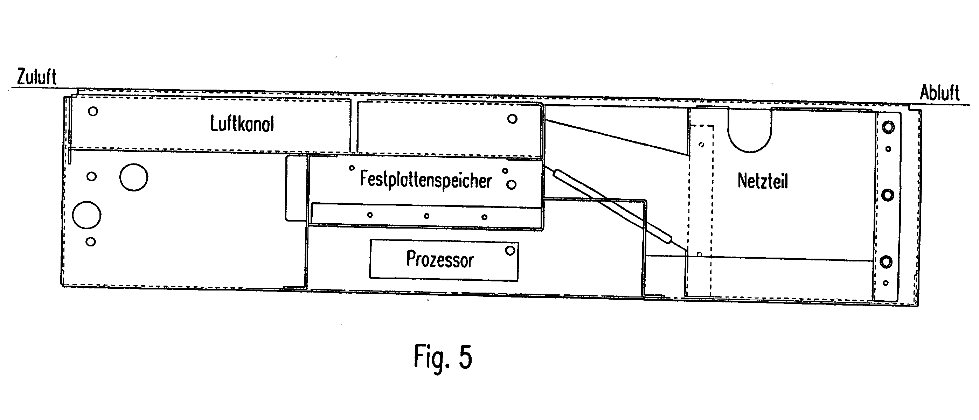

Der Split-Level-Flachaufbau der Gehäuseanordnung sei mit Hilfe der Fig. 5 erläutert.
In einer unteren Ebene befinden sich Quellen größerer Wärmeentwicklung, z.B. ein Prozessor-Schaltkreis. In einer mittleren Ebene mit geringerer Wärmeentwicklung befindet sich beispielsweise ein Festplattenspeicher, dessen obere bevorzugt elektrisch leitfähige Abschlussfläche zu einer oberen Ebene eines Frischluftkanals führt bzw. mit diesem Kanal wärmeseitig in Verbindung steht. Die kühlere Frischluft wird demnach von oben nach unten und anschließend seitlich heraustretend über einen Abluftkanal geführt, wobei im Abluftkanal das Netzteil angeordnet ist und mit einer dort befindlichen Trennwand weitere Baugruppen in Wärmekontakt stehend befindlich sind.

Alles in allem gelingt es mit der vorstehend beschriebenen Gehäuseanordnung in optimaler Weise, die aufgenommenen elektronischen Baugruppen und Komponenten zu kühlen und gleichzeitig für eine geräuschdämmende Lagerung, insbesondere mechanischer Plattenspeicher Sorge zu tragen. Die Gehäuseteile können in einfacher Weise in Stanz- und Biegetechnik, aber auch durch Spritzpressen gefertigt werden, so dass die Kosten insgesamt gering gehalten werden. Durch die seitliche Zu- und Abluftführung wird ein unerwünschtes Anblasen einer Person verhindert, die an der Frontseite befindliche Bedienelemente aktiviert bzw. sich in der Nähe der Frontseite aufhält. Durch die Anordnung des Gebläses bzw. Lüfters im Inneren des Gehäuses weitab von Lufteintritts- oder Luftaustrittsöffnungen wird ein unerwünschtes Berühren des Rotors im Sinne einer Kindersicherung wirksam verhindert.

### Bezugszeichenliste

- 1: Gehäuse
- 2: Bodenplatte
- 3: Formteil für Frischluftkanal
- 4: Deckel
- 41: Lufteintrittsöffnungen
- 42: Luftaustrittsöffnungen
- 5: Lüfter
- 6: Steckverbinderkarte
- 7: elektronische Baugruppe
- 11/12: Befestigungsbolzen
- 21: gehäuseinnenseitige Trennwand
- 22: Halterung für Festplatte
- 23: Abkantung der Trennwand mit Luftdurchtrittsöffnungen zum Abluftkanal
- 24: Abluftkanalteil
- 31: Ausnehmung für Lüfter
- 32: Ausnehmung für weitere zu kühlende Baugruppe, insbesondere Festplatte

## Patentansprüche

1. Gehäuseanordnung zur Aufnahme elektronischer Baugruppen, insbesondere flaches Desktop-PC- oder Multimedia-Gehäuse, umfassend eine Bodenplattle (2), Frontseite und Rückseite sowie einen haubenartigen, abnehmbaren Deckel (4), einen elektromotorischen Lüfter (5) und im Gehäuse gebildete Kammern oder Abschnitte,
**dadurch gekennzeichnet, dass**
- im Gehäuseinneren ein im wesentlichen zur Bodenplatte parallel und von dieser höhenmäßig beabstandet verlaufender Frischluftkanal vorgesehen ist, wobei der Frischluftkanal außer seitlichen Lufteintrittsöffnungen (41, 42) gegen das Gehäuse und den im Gehäuseinneren befindlichen Kammern oder Abschnitten saugseitig abgedichtet ist;
- am lufteintrittsöffnungsfernen Ende des Frischluftkanals eine Ausnehmung (31) zur Aufnahme des Lüfters eingebracht ist, wobei der Lüfter vertikal in die unterhalb des Frischluftkanals befindliche Kammer bläst;
- die untere Kammer mit einem seitlichen Abluftkanal in Verbindung steht, über welchen zwangsgeführt die erwärmte Abluft das Gehäuse seitlich verlässt;
- in Strömungsrichtung unterhalb des Lüfters von diesem angeblasen mindestens eine elektronische Baugruppe (7) und Wärmequelle angeordnet ist; und
- der Ausnehmung zur Aufnahme des Lüfters strömungsseitig vorgeordnet eine weitere Ausnehmung im Frischluftkanal für eine zu kühlende Baugruppe eingebracht ist, wobei diese Baugruppe in die untere Kammer hineinreicht.

2. Anordnung nach Anspruch 1,
**dadurch gekennzeichnet, dass**
der Frischluftkanal aus einem Blechform- oder Spritzgussteil besteht, wobei der haubenartige Deckel seitliche Lufteintrittsöffnungen besitzt und den Frischluftkanal nach oben abdichtet.

3. Anordnung nach Anspruch 1 oder 2,
**dadurch gekennzeichnet, dass**
im seitlichen Abluftkanal eine Stromversorgungs-Baugruppe, insbesondere Schaltnetzteil angeordnet ist und der Abluftkanal von einer gehäuseinnenseitigen Trennwand und dem haubenartigen Deckel gebildet ist, wobei der Deckel seitliche Luftaustrittsöffnungen aufweist.

4. Anordnung nach Anspruch 2 oder 3,
**dadurch gekennzeichnet, dass**
der Deckel eine im wesentlichen U-Form besitzt, wobei in einem Schenkel die Lufteintritts- und im gegenüberliegenden zweiten Schenkel die Luftaustrittsöffnungen eingebracht sind.

5. Anordnung nach Anspruch 3,
**dadurch gekennzeichnet, dass**
weitere zu kühlende Baugruppen an der gehäuseinnenseitigen Trennwand, mit dieser in Wärmekontakt stehend, angeordnet sind.

6. Anordnung nach einem der vorangegangenen Ansprüche,
**dadurch gekennzeichnet, dass**
unterhalb des Lüfters in der unteren Kammer eine CPU mit passivem Kühlkörper angeordnet ist, wobei der Kühlkörper vom Luftstrom angeblasen und der Luftstrom verwirbelt wird.

7. Anordnung nach einem der vorangegangenen Ansprüche,
**dadurch gekennzeichnet, dass**
in der weiteren Ausnehmung die wärmeabgebende Seite eines Festplattenspeichers befindlich ist.

8. Anordnung nach Anspruch 7,
**gekennzeichnet durch**
eine geräuschdämmende Lagerung und Befestigung des Lüfters und/oder der Festplatte innerhalb der jeweiligen Ausnehmungen.

9. Anordnung nach einem der Ansprüche 3 bis 8,
**dadurch gekennzeichnet, dass**
der Lüfter innerhalb der unteren Kammer einen Überdruck aufbaut, wobei die gehäuseinnenseitige Trennwand in einem hinteren Bereich Luftdurchtrittsöffnungen umfasst.

10. Anordnung nach Anspruch 9,
**dadurch gekennzeichnet, dass**
die Trennwand eine doppelte Abkantung aufweist, wodurch eine weitere Kammer zur Aufnahme des insbesondere open-frame-Schaltnetzteils gebildet ist.

11. Anordnung nach Anspruch 10,
**dadurch gekennzeichnet, dass**
die längere Seite der Trennwand parallel und beabstandet zum zweiten Schenkel des Deckels, mindestens bis hin zu den dort vorgesehenen Luftaustrittsöffnungen verläuft.

12. Anordnung nach einem der vorangegangenen Ansprüche,
**dadurch gekennzeichnet, dass**
mindestens eine der in der unteren Kammer angeordneten elektronischen Baugruppen von der Frontseite des Gehäuses über eine Klappe, Schiebeteil oder dergleichen Mittel zugänglich ist.

13. Anordnung nach einem der vorangegangenen Ansprüche,
**gekennzeichnet durch**
folgenden Kühlungsströmungsverlauf:
- seitlicher Lufteintritt mit horizontalem Verlauf innerhalb des Frischluftkanals;
- Richtungsumkehr vertikal nach unten in die untere Kammer mit Überdruckaufbau und Verwirbelung;
- Richtungsumkehr horizontal in den seitlichen Abluftkanal hinein und Abbau des Drucks **durch** seitlichen Luftaustritt über Öffnungen des Gehäuses, die denjenigen für den Lufteintritt gegenüberliegen.

14. Anordnung nach einem der vorangegangenen Ansprüche, **gekennzeichnet durch**
einen Split-Level-Flachaufbau, wobei in einer unteren Ebene Quellen großer Wärmeentwicklung, in einer mittleren Ebene Quellen mittlerer bis geringerer Wärmeentwicklung und in einer oberen Ebene ein Frischluftkanal mit Zwangsströmung befindlich ist, wobei dieser von oben nach unten und seitlich austretend verläuft.

15. Anordnung nach Anspruch 14,
**dadurch gekennzeichnet, dass**
im Bereich des Luftaustritts der unteren Ebene benachbart ein höhenmäßig über alle Ebenen reichender Abluftkanal befindlich ist, in dem mindestens eine weitere thermisch unterkritische Wärmequelle anordenbar ist.

## Claims

1. A housing arrangement for accommodating electronic assemblies, in particular a flat desktop PC or multimedia housing, comprising a bottom plate (2), front and rear sides, as well as a hood-type, removable cover (4), a fan (5) driven by an electric motor, and chambers or sections formed in the housing,
**characterised in that**
- a fresh air duct is provided in the interior of the housing, which extends essentially parallel to the base plate and spaced apart from same at a predetermined height, with the fresh air duct, apart from lateral air intake openings (41, 42), being sealed at the suction side against the housing and the chambers or sections which are located in the interior of the housing;
- at the far end of the air intake opening of the fresh air duct a recess (31) is provided for the accommodation of a fan, with the fan blowing vertically into the chamber located below the fresh air duct;
- the lower chamber is communicating with a lateral exhaust duct, via which the heated exhaust air is positively directed to be laterally discharged from the housing;
- in the flow direction below the fan, at least one electronic assembly(7) and heat source is arranged; and
- upstream of the recess (31) for accommodating the fan, a further recess (32) is provided in the fresh air duct which mounts an assembly to be cooled, with this assembly extending into the lower chamber.

2. The arrangement according to Claim 1,
**characterised in that**
the fresh air duct consists of a sheet metal moulded part or an injection moulded part (3), with the hood-type cover (4) possessing lateral air intake openings (41) and sealing the fresh air duct from above.

3. The arrangement according to Claim 1 or 2,
**characterised in that**
in the lateral exhaust duct a current supply assembly, in particular a switching power supply unit, is arranged and the exhaust duct is formed by a partition wall (21) in the interior of the housing and the hood-type cover (4), with the cover comprising lateral air discharge openings (42).

4. The arrangement according to Claim 2 or 3,
**characterised in that**
the cover (4) has essentially a U shape, with the air intake openings (41) being formed in one leg and the air discharge openings (42) being formed in the opposite second leg.

5. The arrangement according to Claim 3,
**characterised in that**
further assemblies to be cooled are arranged at the partition wall (21) in the interior of the housing being in thermal contact with same.

6. The arrangement according to any of the previous claims,
**characterised in that**
a CPU with passive heat sink is arranged below the fan (5) in the lower chamber, with the air stream blowing against the heat sink and the air stream being made turbulent.

7. The arrangement according to any of the previous claims,
**characterised in that**
the heat emitting side of a hard disk storage is located in the further recess (32).

8. The arrangement according to Claim 7,
**characterised by**
a sound-dampening support and mounting of the fan (5) and/or the hard disk within the respective recess.

9. The arrangement according to any of Claims 3 to 8,
**characterised in that**
the fan (5) builds up an overpressure in the lower chamber, with the partition wall (21) in the interior of the housing comprising air through holes in a rear area.

10. The arrangement according to Claim 9,
**characterised in that**
the partition wall (21) comprises a double bevel (23), by means of which a further chamber for accommodating in particular the open frame switching power supply unit is provided.

11. The arrangement according to Claim 10,
**characterised in that**
the longer side of the partition wall (21) extends parallel and at a distance from the second leg of the cover (4), at least until the air discharge openings (42) provided therein.

12. The arrangement according to any of the previous claims,
**characterised in that**
at least one electronic assembly arranged in the lower chamber is accessible from the front side of the housing via a flap, a sliding part, or similar means.

13. The arrangement according to any of the previous claims,
**characterised by**
the following cooling air stream:
- lateral air intake with horizontal course within the fresh air duct;
- direction reversal vertically downwards into the lower chamber with pressure build-up and turbulence;
- direction reversal horizontally into the lateral exhaust duct and pressure relief by lateral air discharge through openings of the housing, which are opposite those for the air intake.

14. The arrangement according to any of the previous claims,
**characterised by**
a split level construction, with sources of considerable heat generation being located in a lower plane, sources of medium to low heat generation being located in a mid plane, and a fresh air duct with forced flow being located in an upper plane, with said duct extending from top to bottom and exiting laterally.

15. The arrangement according to Claim 14,
**characterised in that**
in the area of the air discharge adjacent to the lower plane, an exhaust duct is located which with respect to height extends over all planes, in which at least one further thermally non-critical heat source can be arranged.

## Revendications

1. Agencement de boîtier pour recevoir des groupes structurels électroniques, en particulier boîtier plat d'ordinateur ou multimédia dit "desktop", comportant une plaque de fond (2), une face frontale et une face arrière ainsi qu'un couvercle amovible (4) en forme de coiffe, un ventilateur (5) à moteur électrique et des chambres ou des cases formées dans le boîtier,
**caractérisé en ce que**
- dans l'intérieur du boîtier est prévu un canal à air frais sensiblement parallèle à la plaque de fond et s'étendant en hauteur à distance de celle-ci, le canal à air frais est étanché du côté aspiration, exception faite d'ouvertures d'entrée d'air latérales (41, 42), par rapport au boîtier et aux chambres ou cases situées à l'intérieur du boîtier,
- à l'extrémité du canal à air frais éloignée des ouvertures d'entrée d'air est ménagé un évidement (31) pour recevoir le ventilateur, le ventilateur soufflant verticalement dans la chambre située au-dessous du canal à air frais,
- la chambre inférieure est en communication avec un canal latéral à air usé via lequel l'air usé chauffé quitte le boîtier latéralement sous guidage forcé,
- au moins un groupe structurel électronique (7) et une source de chaleur sont agencés en direction d'écoulement au-dessous du ventilateur en étant attaqués par le souffle de celui-ci, et
- en amont de l'évidement pour recevoir le ventilateur est ménagé un autre évidement dans le canal à air frais pour un groupe structurel à refroidir, ce groupe structurel pénétrant dans la chambre inférieure.

2. Agencement selon la revendication 1, **caractérisé en ce que** le canal à air frais est constitué par une pièce formée en tôle ou coulée par injection, le couvercle en forme de coiffe présentant des ouvertures d'entrée d'air latérales et étanchant le canal à air frais vers le haut.

3. Agencement selon l'une ou l'autre des revendications 1 et 2, **caractérisé en ce que** dans le canal latéral à air usé est agencé un groupe structurel d'alimentation électrique, en particulier un bloc d'alimentation, et le canal à air usé est formé par une paroi de séparation côté intérieur du boîtier et par le couvercle en forme de coiffe, le couvercle présentant des ouvertures latérales de sortie d'air.

4. Agencement selon l'une ou l'autre des revendications 2 et 3, **caractérisé en ce que** le couvercle possède sensiblement une forme en U, les ouvertures d'entrée d'air étant ménagées dans l'une des branches et les ouvertures de sortie d'air étant ménagées dans la deuxième branche opposée.

5. Agencement selon la figure 3, **caractérisé en ce que** d'autres groupes structurels à refroidir sont agencés sur la paroi de séparation côté intérieur du boîtier en étant en contact thermique avec celle-ci.

6. Agencement selon l'une des revendications précédentes, **caractérisé en ce qu'**une unité centrale comportant un corps de refroidissement passif est agencée au-dessous du ventilateur dans la chambre inférieure, le corps de refroidissement étant attaqué par le souffle du courant d'air et le courant d'air étant mis en tourbillonnement.

7. Agencement selon l'une des revendications précédentes, **caractérisé en ce que** dans l'autre évidement se trouve le côté dégageant la chaleur d'une mémoire à disque dur.

8. Agencement selon la revendication 7, **caractérisé par** un montage et une fixation insonorisant du ventilateur et/ou du disque dur à l'intérieur des évidements respectifs.

9. Agencement selon l'une des revendications 3 à 8, **caractérisé en ce que** le ventilateur établit une surpression à l'intérieur de la chambre inférieure, la paroi de séparation côté intérieur du boîtier présentant des ouvertures de passage d'air dans une zone arrière.

10. Agencement selon la revendication 9, **caractérisé en ce que** la paroi de séparation comprend une feuillure double dont résulte une autre chambre pour recevoir le bloc d'alimentation en particulier du type "open frame".

11. Agencement selon la revendication 10, **caractérisé en ce que** le côté long de la paroi de séparation s'étend parallèlement à et à distance de la deuxième branche du couvercle au moins jusqu'aux ouvertures de sortie d'air qui y sont prévues.

12. Agencement selon l'une des revendications précédentes, **caractérisé en ce que** l'un au moins des groupes structurels électroniques agencés dans la chambre inférieure est accessible depuis la face frontale du boîtier via un volet, une pièce coulissante ou via un moyen similaire.

13. Agencement selon l'une des revendications précédentes, **caractérisé par** le tracé suivant de l'écoulement réfrigérant :
- entrée latérale d'air avec tracé horizontal à l'intérieur du canal à air frais,
- inversion de la direction verticalement vers le bas jusque dans la chambre inférieure avec établissement d'une surpression et avec mise en tourbillonnement,
- inversion de la direction horizontalement jusque dans le canal latéral à air usé et suppression de la pression par sortie d'air latérale via des ouvertures du boîtier opposées à celles de l'entrée d'air.

14. Agencement selon l'une des revendications précédentes, **caractérisé par** une structure plate à plusieurs étages, dans laquelle des sources de développement de chaleur importante sont situées dans un étage inférieur, des sources de développement de chaleur moyenne ou faible sont situées dans un étage médian et un canal à air frais avec écoulement forcé est situé dans un étage supérieur, ledit canal s'étendant depuis le haut vers le bas et sortant latéralement

15. Agencement selon la revendication 14, **caractérisé en ce qu'**il est prévu, dans la zone de la sortie d'air, au voisinage de l'étage inférieur, un canal à air usé qui s'étend en hauteur sur tous les étages et dans lequel peut être agencée au moins une autre source de chaleur thermiquement sous-critique.
